(19) Europäisches Patentamt
European Patent Office
Office européen des brevets

(11) **EP 3 460 902 A1**

(12) **EUROPEAN PATENT APPLICATION**
published in accordance with Art. 153(4) EPC

(43) Date of publication:
**27.03.2019 Bulletin 2019/13**

(51) Int Cl.:
***H01P 1/15*** *(2006.01)*

(21) Application number: **16907240.2**

(22) Date of filing: **28.06.2016**

(86) International application number:
**PCT/JP2016/069109**

(87) International publication number:
**WO 2018/003007 (04.01.2018 Gazette 2018/01)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Mitsubishi Electric Corporation Chiyoda-ku Tokyo 100-8310 (JP)**

(72) Inventors:
- **KOMARU, Ryota Tokyo 100-8310 (JP)**
- **HANGAI, Masatake Tokyo 100-8310 (JP)**
- **YAMANAKA, Koji Tokyo 100-8310 (JP)**
- **SUGIMOTO, Atsuo Tokyo 100-8310 (JP)**

(74) Representative: **Pfenning, Meinig & Partner mbB Patent- und Rechtsanwälte Theresienhöhe 11a 80339 München (DE)**

(54) **HIGH FREQUENCY SWITCH**

(57)    A second transistor (2b), which is turned on when a first transistor (2a) is turned off, is shunt-connected between a first transmission line (3a) and a second transmission line (3b). A fourth transistor (2d), which is turned off when a third transistor (2c) is turned on, is shunt-connected between a third transmission line (3c) and a fourth transmission line (3d). Each of a common terminal transmission line (3e), the first and second transmission lines (3a and 3b), and the third and fourth transmission lines (3c and 3d) is set to have an electrical length of a quarter wavelength at the center frequency of an input signal. The first transistor (2a) and the third transistor (2c) are complementary turned on and off, and characteristic impedances of the common terminal transmission line (3e), the first transmission line (3a), and the third transmission line (3c) are set to be lower than those of peripheral circuits.

FIG. 1

## Description

## TECHNICAL FIELD

The present invention relates to a high frequency switch capable of switching paths of transmission and reception signals.

## BACKGROUND ART

As a conventional high frequency switch, a serial/parallel type high frequency switch described in Non-Patent Literature 1 is known. This high frequency switch includes transistors Q1 and Q2 connected in series to paths from a common terminal COM to input terminals IN1 and IN2, respectively, and shunt-connected transistors Q3 and Q4. In this configuration, when a part between the input terminal IN1 and the common terminal COM is set to a conductive state, the transistors Q1 and Q4 are turned on while the transistors Q2 and Q3 are turned off, and, when a part between the input terminal IN2 and the common terminal COM is set to a conductive state, on/off states of the respective transistors are reversed. In this manner, the path of a high frequency signal is switched over. In a circuit having such a configuration, by increasing gate widths of the transistors Q1 and Q2 connected in series to the input/output paths, saturation currents of the transistors can be increased, and electrical power resistance of the switch can be increased.

## CITATION LIST

## NON-PATENT LITERATURE

Non-Patent Literature 1: "Monolithic Al-GaN/GaN HEMT SPDT switch,"IEEE 12th GaAs Symposium,pp.83-86, 2004.

## SUMMARY OF INVENTION

## TECHNICAL PROBLEM

In a case where a high electrical power resistance switch is configured as described above, it is necessary to increase gate widths of transistors connected in series in order to increase the electrical power resistance. However, there is a problem that off-capacitances and parasitic components of the transistors are increased when the gate widths of the transistors are increased. For example, in a case where a high electrical power resistance characteristic is required when a part between the input terminal IN 1 and the common terminal COM is set to a conductive state, it is necessary to increase the gate width of the transistor Q1. However, generally a transistor with a large gate width has a large capacitance and a large parasitic component when being turned off, and thus it becomes difficult to realize matching over a broadband, thus disadvantageously resulting in a narrow band. Since this circuit is symmetrical, the same problem occurs also when a high electrical power resistance characteristic is required in the path between the input terminal IN2 and the common terminal COM.

The present invention has been devised in order to solve the problem as described above, and it is an object of the present invention to provide a high frequency switch capable of implementing high electrical power resistance characteristics and broadband pass characteristics.

## SOLUTION TO PROBLEM

A high frequency switch according to the present invention includes: a common terminal transmission line whose one end is connected to a common terminal; an inductor whose one end is connected to another end of the common terminal transmission line and whose another end is grounded; a first transistor, a first transmission line, and a second transmission line connected in series between said another end of the common terminal transmission line and a first input/output terminal; a second transistor shunt-connected between the first transmission line and the second transmission line and turned on when the first transistor is turned off; and a second circuit connected between said another end of the common terminal transmission line and a second input/output terminal and having a symmetrical configuration to a first circuit including the first transistor, the second transistor, the first transmission line, and the second transmission line. Each of the common terminal transmission line, the first transmission line, the second transmission line, and each of a third transmission line and a fourth transmission line which are included in the second circuit and correspond to the first transmission line and the second transmission line in the symmetrical configuration, respectively, has an electric length of a quarter wavelength at a center frequency of an input signal. The first transistor and a third transistor, included in the second circuit and corresponds to the first transistor in the symmetrical configuration, are operated to be complementary turned on and off. Characteristic impedance of each of the common terminal transmission line, the first transmission line, and the third transmission line are set to be lower than a characteristic impedance of a peripheral circuit.

## ADVANTAGEOUS EFFECTS OF INVENTION

In the high frequency switch according to the present invention, each of the common terminal transmission line, the first transmission line, the second transmission line, the third transmission line, and the fourth transmission line has an electric length of a quarter wavelength at a center frequency of an input signal. The first transistor and the third transistor are operated to be complementary turned on and off. Characteristic impedance of each of the common terminal transmission line, the first transmission line, and the third transmission line are set to be lower than a characteristic impedance of a peripheral circuit. As a result, high electrical power resistance characteristics and broadband pass characteristics can be implemented.

**BRIEF DESCRIPTION OF DRAWINGS**

FIG. 1 is a configuration diagram of a high frequency switch according to a first embodiment of the present invention;

FIG. 2 is an equivalent circuit diagram when a part between a common terminal and a second input/output terminal in the high frequency switch is set to a conductive state according to the first embodiment of the present invention;

FIG. 3 is an explanatory diagram illustrating a broadband operation in the high frequency switch according to the first embodiment of the present invention;

FIG. 4 is a configuration diagram of a high frequency switch according to a second embodiment of the present invention;

FIG. 5 is an equivalent circuit diagram when a part between a common terminal and an input/output terminal in the high frequency switch is set to a conductive state according to the second embodiment of the present invention;

FIG. 6 is an explanatory diagram illustrating relationship between a fractional bandwidth and isolation with respect to the capacitance value in the high frequency switch according to the second embodiment of the present invention; and

FIG. 7 is a configuration diagram of a high frequency switch according to a third embodiment of the present invention.

**DESCRIPTION OF EMBODIMENTS**

To describe the present invention further in detail, some embodiments for carrying out the present invention will be described below with reference to the accompanying drawings.

First Embodiment.

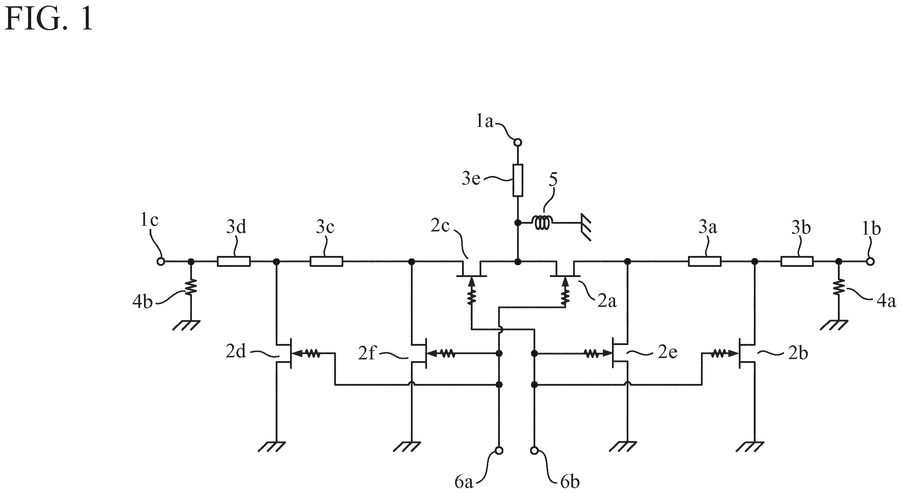

FIG. 1 is a configuration diagram of a high frequency switch according to the present embodiment.

The illustrated high frequency switch includes a common terminal 1a, a first input/output terminal 1b, a second input/output terminal 1c, a first transistor 2a, a second transistor 2b, a third transistor 2c, a fourth transistor 2d, a fifth transistor 2e, a sixth transistor 2f, a first transmission line 3a, a second transmission line 3b, a third transmission line 3c, a fourth transmission line 3d, a common terminal transmission line 3e, a first resistor 4a, a second resistor 4b, an inductor 5, a first control terminal 6a, and a second control terminal 6b.

The high frequency switch of the present embodiment is a single pole double throw switch which performs switching of the common terminal 1a, the first input/output terminal 1b, and the second input/output terminal 1c. Specifically, the high frequency switch of the present embodiment switches a path of a signal input from the common terminal 1a by turning on or off the first transistor 2a to the sixth transistor 2f to output the signal to the first input/output terminal 1b or the second input/output terminal 1c. Note that, similar pass characteristics are also shown in a case where an input signal is output through a reverse path, that is, a case where a signal input from the first input/output terminal 1b is output to the common terminal 1a or a signal input from the second input/output terminal 1c is output to the common terminal 1a.

Each of the gate terminals of the first transistor 2a to the sixth transistor 2f is connected to a resistor having a high resistance value and is connected to the first control terminal 6a or the second control terminal 6b via the resistor. As for a voltage applied to each of the transistors, applying a voltage equal to or larger than a pinch-off voltage to a gate terminal results in an on-state between drain and source of the transistor, and applying a voltage equal to or smaller than the pinch-off voltage to the gate terminal results in an off-state between the drain and the source. A transistor in the on-state can be regarded as a resistance, and a transistor in the off-state can be regarded as a capacitance. Hereinafter, these resistance and capacitance are referred to as the on-resistance and the off-capacitance of the transistor, respectively.

Each of the first transmission line 3a to the common terminal transmission line 3e operates as an impedance conversion circuit whose electrical length is the quarter wavelength at the center frequency of an input signal. Furthermore, an inductance of the inductor 5 is set so as to realize parallel resonance at a required center frequency in order to cancel out the off-capacitance of the first transistor 2a or the third transistor 2c. Note that, the common terminal transmission line 3e and the inductor 5 are provided as a matching circuit among the common terminal 1a, the first transistor 2a, and the third transistor 2c.

Furthermore, the first resistor 4a and the second resistor 4b operate as grounding resistors for stabilizing potentials of drain and source terminals of transistors and are set to a high resistance value so as not to influence the passing loss of a high frequency signal.

In the high frequency switch of the first embodiment, one end of the common terminal transmission line 3e is connected to the common terminal 1a as illustrated in FIG. 1. The other end of the common terminal transmission line 3e is connected to one end of the inductor 5, and the other end of the inductor 5 is grounded. Between the other end of the common terminal transmission line 3e and the first input/output terminal 1b, the first transistor 2a, the first transmission line 3a, and the second transmission line 3b are connected in series. Between the first transistor 2a and the first transmission line 3a, the fifth transistor 2e, which is turned off when the first transistor 2a is turned on, is shunt-connected. Between the first transmission line 3a and the second transmission line 3b, the second transistor 2b, which is turned off when the first transistor 2a is turned on, is shunt-connected. Between the second transmission line 3b and the first input/output terminal 1b, one end of the first resistor 4a is connected, and the other end thereof is grounded. In addition, the second circuit including the third transistor 2c, the fourth transistor 2d, the sixth transistor 2f, the third transmission line 3c, the fourth transmission line 3d, the second resistor 4b, and the second control terminal 6b are provided between the common terminal transmission line 3e and the second input/output terminal 1c. The second circuit forms a pair with the circuit including the first transistor 2a, the second transistor 2b, the fifth transistor 2e, the first transmission line 3a, the second transmission line 3b, the first resistor 4a, and the first control terminal 6a.

Next, the operation of the high frequency switch according to the first embodiment will be described.

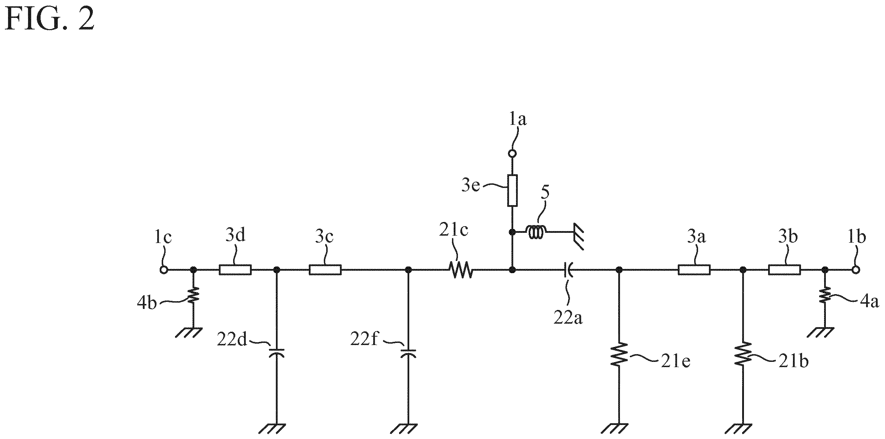

In FIG. 2, an equivalent circuit when a part between the common terminal 1a and the second input/output terminal 1c is set to a conductive state is illustrated. In this operation, a voltage equal to or smaller than the pinch-off voltage is applied from the first control terminal 6a to the first transistor 2a, the fourth transistor 2d, and the sixth transistor 2f so that they operate in an off-state, and they are regarded as off-capacitances 22a, 22d, 22f, respectively. On the other hand, a voltage larger than the pinch-off voltage is applied from the second control terminal 6b to the second transistor 2b, the third transistor 2c, and the fifth transistor 2e so that they operate in an on-state, and thus they can be regarded as on-resistances 21b, 21c, and 21e, respectively.

In this case, since the off-capacitances 22a, 22d, and 22f of the transistors are large impedances at a frequency of an input signal while the on-resistances 21b, 21c, and 21e are sufficiently small, a signal input from the common terminal 1a is output to the second input/output terminal 1c.

Here, electrical power resistance of a transistor in the on-state will be described. In an on-state transistor, an RF current IRF flows in accordance with input power Pin. In a case where each resistance value is sufficiently small, the current value thereof is represented by:

$$ IRF = \sqrt{(2Pin/Z0)}. $$

The maximum electrical power resistance Pmax of an on-state transistor satisfies Pmax ≤ Z0Idss$^2$/2, using a saturation current value Idss at a gate voltage of 0 V. Here, Z0 denotes the impedance of the system. Furthermore, the saturation current value Idss of the transistor satisfies the relationship:

$$ Idss = Idss0 \cdot WG $$

where WG represents the gate width of the transistor, and Idss0 represents the saturation current value per unit gate width.

Furthermore, the relationship regarding the on-resistance Ron and the off-capacitance Coff of a transistor with respect to sthe gate width is represented by Ron = Ron0/WG and Coff = Coff0·WG, where Ron0 represents the on-resistance per unit gate width, and Coff0 represents the off-capacitance per unit gate width.

Therefore, in order to improve electrical power resistance in this configuration, it is necessary to increase the gate width of a transistor. However, by increasing the gate width of a transistor, a parasitic component increases due to the off-capacitance and the transistor size.

In the present embodiment, therefore, transistors with a large gate width are used by setting characteristic impedances of the common terminal transmission line 3e, the first transmission line 3a, and the third transmission line 3c to be lower than those of peripheral circuits. Here, the peripheral circuits refer to circuits connected to the high frequency switch, which are connected to the common terminal 1a, the first input/output terminal 1b, and the second input/output terminal 1c. Such circuits include, for example, an amplifier, a filter, an antenna, a feeding circuit to an antenna, and the like, and these circuits are generally designed by a 50 Ω system in a microwave circuit. Moreover, in the present embodiment, each of the common terminal transmission line 3e, the first transmission line 3a, the second transmission line 3b, the third transmission line 3c, and the fourth transmission line 3d is set to have an electrical length of a quarter wavelength at the center frequency of an input signal.

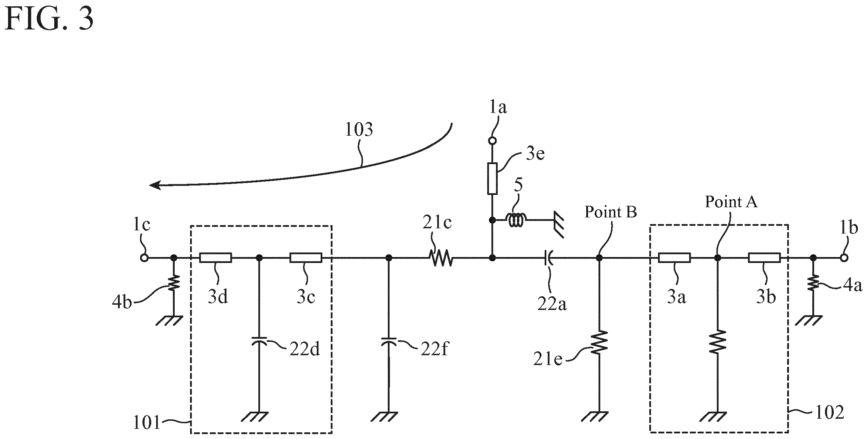

In FIG. 3, an operation of a broadband circuit according to the first embodiment is illustrated.

In this circuit, a circuit formed by the third transmission line 3c, the fourth transmission line 3d, and the off-capacitance 22d of the fourth transistor 2d operates as a circuit for broadband operation. This is because a broadband matching circuit 101 is formed by two stages of impedance transformer circuits of the third transmission line 3c and the fourth transmission line 3d and the off-capacitance 22d of the fourth transistor 2d that is shunt-connected, and as a result, matching over a broadband can be performed by manipulating a characteristic impedance and a capacitance value of a line.

On the other hand, the circuit formed by the first transmission line 3a, the second transmission line 3b, and the on-resistance 21b of the second transistor 2b on the side of the first input/output terminal 1b arranged symmetrically to the above circuit operates as an isolation circuit 102. This is because the point A can be regarded as substantially short-circuited since the resistance value of the on-resistance 21b is sufficiently small, and further because the impedance when viewed from point B to the second input/output terminal 1c side can be made to be substantially open since the electrical length of the first transmission line 3a is set to the quarter wavelength. Therefore, an input signal flows from the common terminal 1a to the second input/output terminal 1c as indicated by the arrow 103.

With such an operation, in the high frequency switch according to the present embodiment, broadband pass characteristics can be obtained even when a transistor having a large gate width is used to enhance the electrical power resistance characteristics.

As described above, according to the high frequency switch of the first embodiment, a high frequency switch includes: a common terminal transmission line whose one end is connected to a common terminal; an inductor whose one end is connected to another end of the common terminal transmission line and whose another end is grounded; a first transistor, a first transmission line, and a second transmission line connected in series between said another end of the common terminal transmission line and a first input/output terminal; a second transistor shunt-connected between the first transmission line and the second transmission line and turned on when the first transistor is turned off; and a second circuit connected between said another end of the common terminal transmission line and a second input/output terminal and having a symmetrical configuration to a first circuit including the first transistor, the second transistor, the first transmission line, and the second transmission line. Each of the common terminal transmission line, the first transmission line, the second transmission line, and each of a third transmission line and a fourth transmission line which are included in the second circuit and correspond to the first transmission line and the second transmission line in the symmetrical configuration, respectively, has an electric length of a quarter wavelength at a center frequency of an input signal. The first transistor and a third transistor, included in the second circuit and corresponds to the first transistor in the symmetrical configuration, are operated to be complementary turned on and off. Characteristic impedance of each of the common terminal transmission line, the first transmission line, and the third transmission line are set to be lower than a characteristic impedance of a peripheral circuit. As a result, high electrical power resistance characteristics and broadband pass characteristics can be achieved.

Second Embodiment.

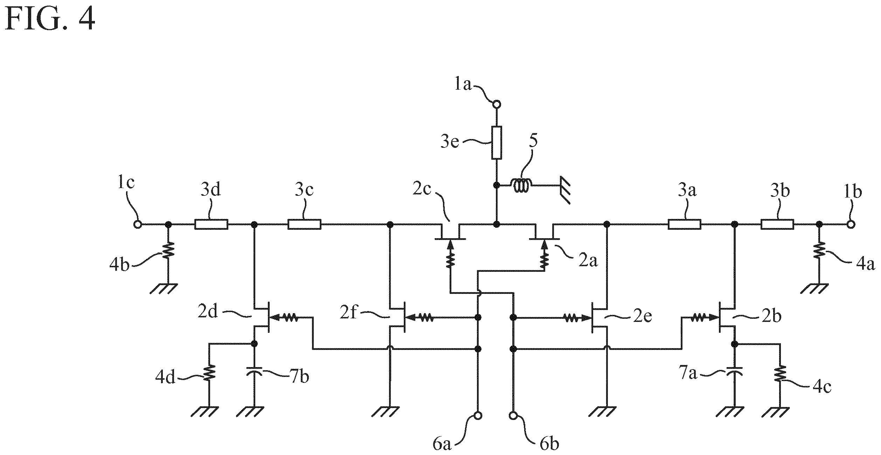

FIG. 4 is a configuration diagram of a high frequency switch according to a second embodiment.

In a circuit configuration of the second embodiment, a parallel circuit of a third resistor 4c and a first capacitive element 7a is additionally connected between the second transistor 2b and the ground in the first circuit of the first embodiment, and a parallel circuit of a fourth resistor 4d and a second capacitive element 7b is additionally connected between the fourth transistor 2d and the ground in the second circuit of the first embodiment. Other configurations are the same to those of the first embodiment illustrated in FIG. 1, and thus the same symbols are used to corresponding parts and description thereof will be omitted.

Like the first resistor 4a and the second resistor 4b, the third resistor 4c and the fourth resistor 4d operate as grounding resistors for stabilizing potentials of drain and source terminals of transistors and are set to have high resistance values, respectively, so as not to influence the passing loss of a high frequency signal. Furthermore, capacitance values of the first capacitive element 7a and the second capacitive element 7b are set to be smaller than off-capacitances of the second transistor 2b and the fourth transistor 2d, respectively.

Next, the operation of the high frequency switch according to the second embodiment will be described.

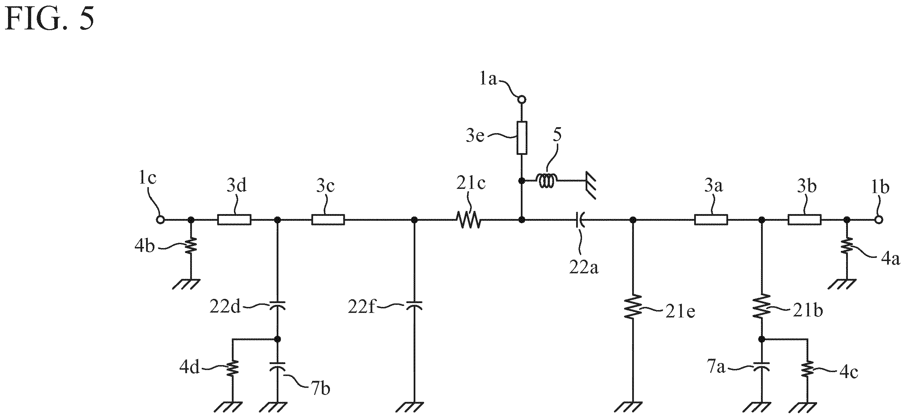

In FIG. 5, an equivalent circuit, when a part between the common terminal 1a and the second input/output terminal 1c is set to a conductive state, is illustrated. Similarly to the operation according to the first embodiment, also in the second embodiment, a voltage equal to or smaller than the pinch-off voltage is applied from a first control terminal 6a to the first transistor 2a, the fourth transistor 2d, and the sixth transistor 2f so that they operate in an off-state, and a voltage larger than the pinch-off voltage is applied from a second control terminal 6b to the second transistor 2b, a third transistor 2c, and a fifth transistor 2e so that they operate in an on-state. As a result, a signal input from the common terminal 1a is output to the second input/output terminal 1c.

In the circuit configuration according to the second embodiment, a combined capacitance of an off-capacitance 22d of the fourth transistor 2d and a capacitance of the second capacitive element 7b has a capacitance value that is shunt-connected. By representing the capacitance value of the off-capacitance 22d as Coff1, and the capacitance value of the second capacitive element 7b as C1, the combined capacitance value Ct is represented by: $Ct = (Coff1 + C1)/(Coff1 \times C1)$.

Here, since the off-capacitance of a transistor is determined in accordance with the gate width of the transistor as described before, it is difficult to set the capacitance value to a small value only by the capacitance value of the transistor itself. Therefore, by loading a fixed capacitance in series, a value smaller than the off-capacitance value of the transistor can be set as a combined capacitance. Therefore, it is possible to implement setting for operation in a high frequency band.

On the other hand, in the isolation circuit on the first input/output terminal 1b side formed by the first transmission line 3a, the second transmission line 3b, the second transistor 2b, and the first capacitive element 7a, since the capacitance of the first capacitive element 7a is loaded in series to the on-resistance 21b of the second transistor 2b, the isolation amount due to the isolation circuit is decreased. Therefore, in the pass characteristics according of this configuration, the broadband characteristics and the isolation have a trade-off relationship with respect to a ratio of the off-capacitance of the transistor and the fixed capacitance.

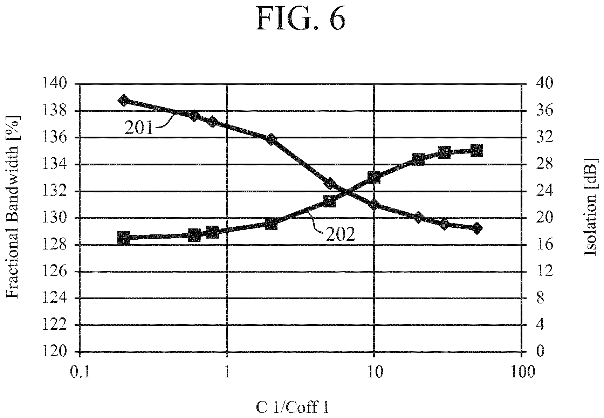

In FIG. 6, a relationship between the fractional bandwidth and isolation with respect to the ratio of capacitances C1/Coff1 is illustrated as a calculation example of the pass characteristics according to the second embodiment. The characteristics 201 represent the fractional bandwidth, and the characteristics 202 represent the isolation. As can be seen from this calculation result, by decreasing the capacitance value C1 of the second capacitive element 7b, it is possible to increase the fractional bandwidth. Therefore, by adopting a configuration in which the relation C1/Coff1 < 1 is satisfied, broadband characteristics can be achieved while degradation of isolation is suppressed.

As described above, a high frequency switch according to the second embodiment includes: a parallel circuit comprising a first capacitive element and a third resistor connected between the second transistor and the ground; and a parallel circuit comprising a second capacitive element and a fourth transistor connected between the fourth transistor in the second circuit and the ground, the fourth transistor corresponding to the second transistor in the symmetrical configuration. A capacitance value of the first capacitive element and a capacitance value of the second capacitive element are set to be smaller than an off-capacitance of the second transistor and an off-capacitance of the fourth transistor, respectively. Therefore, broadband characteristics can be achieved while degradation of isolation is suppressed.

Third Embodiment.

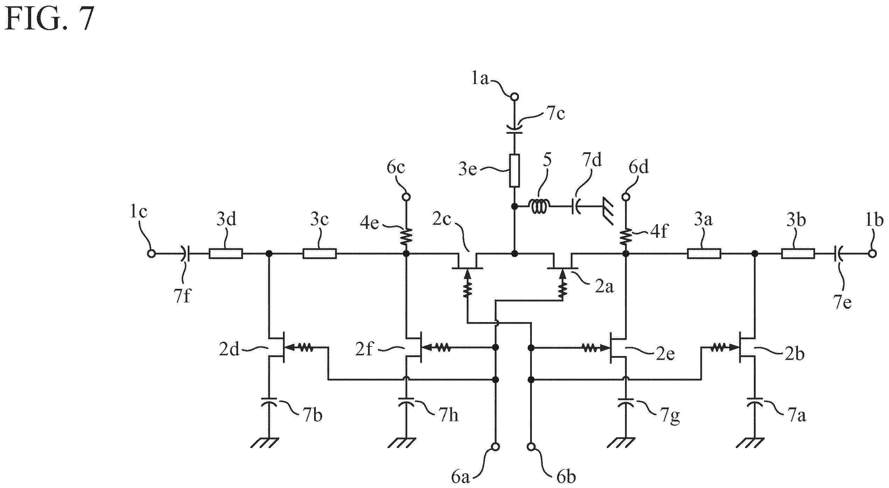

FIG. 7 is a configuration diagram of a high frequency switch according to a third embodiment.
The high frequency switch of the third embodiment is obtained by connecting a third capacitive element 7c to an eighth capacitive element 7h between a common terminal 1a and each of a first input/output terminal 1b, a second input/output terminal 1c, and the ground in the high frequency switch of the first embodiment, and further providing third and fourth control terminals 6c and 6d to allow voltages to be applied to the circuit via a fifth resistor 4e and a sixth resistor 4f. With this, the first resistor 4a and the second resistor 4b of the first embodiment are removed. Further, the first capacitive element 7a is connected between a second transistor 2b and the ground, and a second capacitive element 7b is connected between a fourth transistor 2d and the ground. The third and fourth control terminals 6c and 6d are connected to points where no current flows when a direct current is applied between the common terminal 1a and the first input/output terminal 1b, the second input/output terminal 1c, or the ground. In the illustrated example, the third control terminal 6c is connected to a connection point of a third transistor 2c and a third transmission line 3c via the fifth resistor 4e, and the fourth control terminal 6d is connected to a connection point of a first transistor 2a and a first transmission line 3a via the sixth resistor 4f.
The third capacitive element 7c is connected between the common terminal 1a and a common terminal transmission line 3e. The fourth capacitive element 7d is connected between an inductor 5 and the ground. The fifth capacitive element 7e is connected between a second transmission line 3b and the first input/output terminal 1b, and the sixth capacitive element 7f is connected between a fourth transmission line 3d and the second input/output terminal 1c. In addition, the seventh capacitive element 7g is connected between a fifth transistor 2e and the ground, and the eighth capacitive element 7h is connected between a sixth transistor 2f and the ground.
Next, an operation of the high frequency switch of the third embodiment in a case where a part between the common terminal 1a and the second input/output terminal 1c is set to be a conductive state will be described.
In the circuit configuration according to the third embodiment, since the first capacitive element 7a to the eighth capacitive element 7h are connected, drains and sources of transistors of the entire circuit are not directly grounded, and each potential is determined in accordance with a voltage applied to the third and fourth control terminals 6c and 6d. At this time, regarding the on/off operation of the transistors, when a voltage applied from a first control terminal 6a is denoted as Vc1, a voltage applied from a second control terminal 6b is denoted as Vc2, and the voltage applied from the third and fourth control terminals 6c and 6d is denoted as Vd, the gate-to-source potential and the gate-to-drain potential of each of the first transistor 2a, the sixth transistor 2f, and the fourth transistor 2d are Vc1 - Vd, and the gate-to-source potential and the gate-to-drain potential of each of the second transistor 2b, the third transistor 2c, and the fifth transistor 2e are Vc2 - Vd.
In this configuration, therefore, even in a case where only a positive voltage can be applied to the high frequency switch, by applying the voltage Vd from the third and fourth control terminals 6c and 6d, it is possible to set a potential difference between the gate and the source and a potential difference between the gate and the drain of the transistor to be a minus value using a difference from the voltage Vd. Therefore, by setting the voltage Vc1 - Vd to be equal to or smaller than the pinch-off voltage, the first transistor 2a, the sixth transistor 2f, and the fourth transistor 2d operate in the off-state, and by setting the voltage Vc2 - Vd to be larger than the pinch-off voltage, the second transistor 2b, the third transistor 2c, and the fifth transistor 2e operate in the on-state. Consequently, a signal input from the common terminal 1a is output to the second input/output terminal 1c.
The operation in this embodiment is similar to that of the high frequency switch according to the second embodiment other than the voltage setting described above. In the circuit configuration according to the third embodiment, since the third control terminal 6c is provided for positive voltage driving, even in the case where a DC cut for maintaining a potential in the switch circuit is added, additional circuit elements can be reduced, or a capacitance value used as the DC cut can be reduced, while implementing a broadband circuit in which degradation of isolation is suppressed.

As described above, the high frequency switch includes: a first control terminal connected to a gate terminal of the first transistor and a gate terminal of a fourth transistor in the second circuit corresponding to the second transistor in the symmetrical configuration; a second control terminal connected to a gate terminal of the third transistor and a gate terminal of the second transistor; third and fourth control terminals connected to points where no current flows when a direct current is applied between the common terminal and the first input/output terminal, the second input/output terminal, or the ground; a first capacitive element connected between the second transistor and the ground; a second capacitive element connected between the fourth transistor and the ground; a third capacitive element connected between the common terminal and the common terminal transmission line; a fourth capacitive element connected between the inductor and the ground; a fifth capacitive element connected between the first input/output terminal and the second transmission line; and a sixth capacitive element connected between the second input/output terminal and the fourth transmission line. Capacitance values of the first capacitive element and the second capacitive element are set to be smaller than off-capacitances of the second transistor and the fourth transistor, respectively. Therefore, even when a DC cut for maintaining a potential in the switch circuit is added, additional circuit elements can be reduced, and a capacitance value used as the DC cut can be reduced.

Note that, within the scope of the present invention, the present invention may include a flexible combination of the respective embodiments, a modification of any component of the respective embodiments, or an omission of any component in the respective embodiments.

## INDUSTRIAL APPLICABILITY

As described above, the present invention relates to a high frequency switch capable of switching paths of transmission and reception signals, and it is suitable for use as a single pole double throw switch which switches a path of a signal input from a common terminal and outputs the signal to the first input/output terminal or the second input/output terminal.

## REFERENCE SIGNS LIST

1a: Common terminal, 1b: First input/output terminal, 1c: Second input/output terminal, 2a: First transistor, 2b: Second transistor, 2c: Third transistor, 2d: Fourth transistor, 2e: Fifth transistor, 2f: Sixth transistor, 3a: First transmission line, 3b: Second transmission line, 3c: Third transmission line, 3d: Fourth transmission line, 3e: Common terminal transmission line, 4a: First resistor, 4b: Second resistor, 4c: Third resistor, 4d: Fourth resistor, 4e: Fifth resistor, 4f: Sixth resistor, 5: Inductor, 6a: First control terminal, 6b: Second control terminal, 6c: Third control terminal, 6d: Fourth control terminal, 7a: First capacitive element, 7b: Second capacitive element, 7c: Third capacitive element, 7d: Fourth capacitive element, 7e: Fifth capacitive element, 7f: Sixth capacitive element, 7g: Seventh capacitive element, 7h: Eighth capacitive element, 21b, 21c, 21e: On-resistance, 22a, 22d, 22f: Off-capacitance, 101: Broadband matching circuit, 102: Isolation circuit

## Claims

1. A high frequency switch comprising:

   a common terminal transmission line whose one end is connected to a common terminal;
   an inductor whose one end is connected to another end of the common terminal transmission line and whose another end is grounded;
   a first transistor, a first transmission line, and a second transmission line connected in series between said another end of the common terminal transmission line and a first input/output terminal;
   a second transistor shunt-connected between the first transmission line and the second transmission line and turned on when the first transistor is turned off; and
   a second circuit connected between said another end of the common terminal transmission line and a second input/output terminal and having a symmetrical configuration to a first circuit including the first transistor, the second transistor, the first transmission line, and the second transmission line,
   wherein each of the common terminal transmission line, the first transmission line, the second transmission line, and each of a third transmission line and a fourth transmission line which are included in the second circuit and correspond to the first transmission line and the second transmission line in the symmetrical configuration, respectively, has an electric length of a quarter wavelength at a center frequency of an input signal,
   the first transistor and a third transistor, included in the second circuit and corresponds to the first transistor in the symmetrical configuration, are operated to be complementary turned on and off, and

characteristic impedance of each of the common terminal transmission line, the first transmission line, and the third transmission line are set to be lower than a characteristic impedance of a peripheral circuit.

2. The high frequency switch according to claim 1, further comprising:

a parallel circuit comprising a first capacitive element and a third resistor connected between the second transistor and the ground; and
a parallel circuit comprising a second capacitive element and a fourth transistor connected between the fourth transistor in the second circuit and the ground, the fourth transistor corresponding to the second transistor in the symmetrical configuration,
wherein a capacitance value of the first capacitive element and a capacitance value of the second capacitive element are set to be smaller than an off-capacitance of the second transistor and an off-capacitance of the fourth transistor, respectively.

3. The high frequency switch according to claim 1, further comprising:

a first control terminal connected to a gate terminal of the first transistor and a gate terminal of a fourth transistor in the second circuit corresponding to the second transistor in the symmetrical configuration;
a second control terminal connected to a gate terminal of the third transistor and a gate terminal of the second transistor;
third and fourth control terminals connected to points where no current flows when a direct current is applied between the common terminal and the first input/output terminal, the second input/output terminal, or the ground;
a first capacitive element connected between the second transistor and the ground;
a second capacitive element connected between the fourth transistor and the ground;
a third capacitive element connected between the common terminal and the common terminal transmission line;
a fourth capacitive element connected between the inductor and the ground;
a fifth capacitive element connected between the first input/output terminal and the second transmission line; and
a sixth capacitive element connected between the second input/output terminal and the fourth transmission line,
wherein capacitance values of the first capacitive element and the second capacitive element are set to be smaller than off-capacitances of the second transistor and the fourth transistor, respectively.

EP 3 460 902 A1

FIG. 1

FIG. 2

FIG. 3

# FIG. 4

EP 3 460 902 A1

FIG. 5

EP 3 460 902 A1

# FIG. 6

FIG. 7

# EP 3 460 902 A1

<table>
<tr><td colspan="2"><strong>INTERNATIONAL SEARCH REPORT</strong></td><td>International application No.<br>PCT/JP2016/069109</td></tr>
</table>

**A. CLASSIFICATION OF SUBJECT MATTER**
*H01P1/15*(2006.01)i

According to International Patent Classification (IPC) or to both national classification and IPC

**B. FIELDS SEARCHED**

Minimum documentation searched (classification system followed by classification symbols)
H01P1/15

Documentation searched other than minimum documentation to the extent that such documents are included in the fields searched
Jitsuyo Shinan Koho      1922-1996   Jitsuyo Shinan Toroku Koho   1996-2016
Kokai Jitsuyo Shinan Koho   1971-2016   Toroku Jitsuyo Shinan Koho   1994-2016

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | US 5081706 A  (TEXAS INSTRUMENTS INC.),<br>14 January 1992 (14.01.1992),<br>(Family: none) | 1-3 |
| A | US 4978932 A  (COMMUNICATIONS SATELLITE CORP.),<br>18 December 1990 (18.12.1990),<br>(Family: none) | 1-3 |
| A | US 2009/0298443 A1  (NATIONAL ICT AUSTRALIA LTD.),<br>03 December 2009 (03.12.2009),<br>(Family: none) | 1-3 |
| A | JP 2007-201634 A  (Mitsubishi Electric Corp.),<br>09 August 2007 (09.08.2007),<br>& US 2007/0171000 A1 | 1-3 |

☒ Further documents are listed in the continuation of Box C.   ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>19 July 2016 (19.07.16) | Date of mailing of the international search report<br>02 August 2016 (02.08.16) |
|---|---|
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (January 2015)

16

**INTERNATIONAL SEARCH REPORT**

International application No.

PCT/JP2016/069109

C (Continuation). DOCUMENTS CONSIDERED TO BE RELEVANT

| Category* | Citation of document, with indication, where appropriate, of the relevant passages | Relevant to claim No. |
|---|---|---|
| A | JP 2016-10045 A (Toshiba Corp.), 18 January 2016 (18.01.2016), & US 2015/0381168 A1 | 1-3 |
| A | JP 10-335901 A (Nippon Telegraph and Telephone Corp.), 18 December 1998 (18.12.1998), (Family: none) | 1-3 |
| A | JP 3-258126 A (Sony Corp.), 18 November 1991 (18.11.1991), & US 5193218 A      & EP 446050 A2 | 1-3 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Monolithic AlGaN/GaN HEMT SPDT switch. *IEEE 12th GaAs Symposium,* 2004, 83-86